## Europäisches Patentamt

## European Patent Office

## Office européen des brevets

(11) Publication number: **0 147 205**
**B1**

## EUROPEAN PATENT SPECIFICATION

(45) Date of publication of patent specification: **08.08.90**

(51) Int. Cl.⁵: **G 06 F 15/70, G 01 N 21/88**

(21) Application number: **84308998.8**

(22) Date of filing: **21.12.84**

(54) Pattern inspection.

(30) Priority: **27.12.83 JP 249318/83**

(43) Date of publication of application:
**03.07.85 Bulletin 85/27**

(45) Publication of the grant of the patent:
**08.08.90 Bulletin 90/32**

(84) Designated Contracting States:
**DE FR GB**

(56) References cited:
**EP-A-0 054 598**
**EP-A-0 129 751**
**WESCON TECHNICAL PAPERS, vol. 19, 1975, pages 4/1.1 - 4/1.7; T.S. GROD et al.:**
**"Computer-aided design and pattern generation, the modern input to mask making"**

(73) Proprietor: **FUJITSU LIMITED**
**1015, Kamikodanaka Nakahara-ku**
**Kawasaki-shi Kanagawa 211 (JP)**

(72) Inventor: **Matsui, Showgo c/o Futitsu Lim.Patent Dep.**
**1015 Kamikodanaka Nakahara-ku Kawasaki-shi Kanagawa. 211 (JP)**
Inventor: **Kobayashi, Kenichi c/o Futitsu Lim Patent Dep.**
**1015 Kamikodanaka Nakahara-ku Kawasaki-shi Kanagawa. 211 (JP)**

(74) Representative: **Sunderland, James Harry et al**
**HASELTINE LAKE & CO Hazlitt House 28 Southampton Buildings Chancery Lane London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to pattern inspection.

Patterns used in connection with recent VLSI's, particularly patterns for a 256 K-bit or for a 1 M-bit memory, etc., are almost entirely oriented towards high integration density and large capacity. For example, from the point of view of the level of original data used for (controlling) a pattern generator, etc., used to form such patterns, as many as 107 patterns are mounted on a single chip with an integration density of 5000 patterns/mm$^2$ or more. Meanwhile, inspection of high density patterning of a reticle, formed by a pattern generator on the basis of original data, or of a mask substrate or mask, has often involved comparisons and collation of a signal obtained by scanning the mask substrate and a signal of the same level obtained from the original data held on magnetic tape.

EP—A—0 129 751, which forms part of the state of the art by virtue of Article 54(3) EPC, discloses a method of pattern inspection employing in respect of a selected one of a plurality of patterns, each having the same shape and size, comparison of a signal obtained by scanning the pattern on a photomask reticle and a signal derived from converted original data. Inspection of the remaining such patterns is carried out by comparison with the selected one pattern, not with converted original data.

EP—A—0 056 598 discloses a form of pattern comparison (infrared analysis of circuitry in operation) based on a numerical comparison of digitised signals derived by examination of a reference object and a test object.

At the VLSI level an excessively great quantity of original data is involved.

In this case, it must be considered to be a problem that original data stored on a magnetic tape for example must be converted to original pattern data in accordance with the scanning of a mask substrate in the course of inspection, and that a pattern density is increased, the original data is more complicated and a longer time is required for conversion of original data corresponding to a constant scanning range to original pattern data. As a result, the speed of scanning of a mask substrate must be reduced and inspection time itself is increased.

The present invention can provide a method of pattern inspection and pattern inspection apparatus which enables inspection to be carried out in a shorter time.

The present invention can provide for a curtailment of the time required for inspecting patterning on a mask substrate for (for use in production) a memory, and can afford simplification of apparatus for pattern inspection. In the present invention use is made of the fact that such a memory and other typical VLSI's for example have high density patterning with a repeated pattern portion where basic patterns, for example cells, are formed repeatedly.

The present invention provides a method of pattern inspection and pattern inspection apparatus capable of inspecting at a high speed a high density pattern having a repeated pattern portion for example like a mask substrate, such as a reticle or a mask used for a very large-scale integration (VLSI) memory, etc.

According to the present invention there is provided a method of pattern inspection, comprising comparison of a signal obtained by scanning a mask substrate having high density patterning with a repeated pattern portion, in which a basic pattern is repeated, and a signal obtained from original data designating the high density patterning; which method involves:

repeatedly comparing pattern inspection data, corresponding to the signal obtained by scanning the mask substrate, and repeated basic pattern data, corresponding to the basic pattern of the repeated pattern portion, when inspecting the repeated pattern portion, and

comparing pattern inspection data, corresponding to the signal obtained by scanning the mask substrate, and original pattern data obtained by sequentially converting the original data in synchronization with the scanning, when inspecting a portion of the high density patterning other than the repeated pattern portion.

According to the present invention there is provided pattern inspection apparatus, for inspecting high density patterning on a mask substrate, formed on the basis of original data, the high density patterning having a repeated pattern portion in which a basic pattern is repeated, the apparatus comprising:

a scanning means operable to photo-electrically convert an optical signal obtained by scanning the mask substrate and to output a pattern inspection signal,

an A/D conversion means operable to convert the pattern inspection signal from analog to digital form and to output pattern inspection data,

an original data conversion means operable to sequentially convert the original data of the high density patterning in synchronization with the scanning and to output original pattern data,

an original pattern memory means operable to temporarily store the original pattern data,

an input means operable to input repeated basic bit pattern data, corresponding to the basic pattern of the repeated pattern portion, to the original pattern memory means, and

a control and comparison means operable to input the repeated basic pattern data to the original pattern memory means from the input means when the scanning means scans the repeated pattern portion and to repeatedly compare such dats with the pattern inspection data, and operable to input the original pattern data to the original pattern memory means from the original data conversion means when the scanning means scans a region other than the repeated pattern portion and to sequentially compare such data with the pattern inspection data.

Reference is made, by way of example, to the accompanying drawings, in which:—

Fig. 1 is a schematic plan view of a mask substrate,

Fig. 2 is a scanning plan view, to an enlarged scale, of a repeated pattern portion on the mask substrate of Fig. 1,

Fig. 3 is a schematic block diagram of a pattern inspection apparatus embodying the present invention.

Fig. 4 is a schematic plan view for assistance in explaining scanning of a mask substrate as carried out in an embodiment of the present invention.

Figure 5 is a schematic plan view diagram for assistance in explaining a basic pattern,

Figure 6 is a waveform diagram illustrating a pattern inspection signal provided in an embodiment of the present invention,

Figure 7 is a schematic diagram of a data format indicating pattern inspection data, original pattern data and repeated basic pattern data, etc. provided in an embodiment of the present invention, and

Figure 8 is a waveform diagram illustrating a comparison signal provided in an embodiment of the present invention.

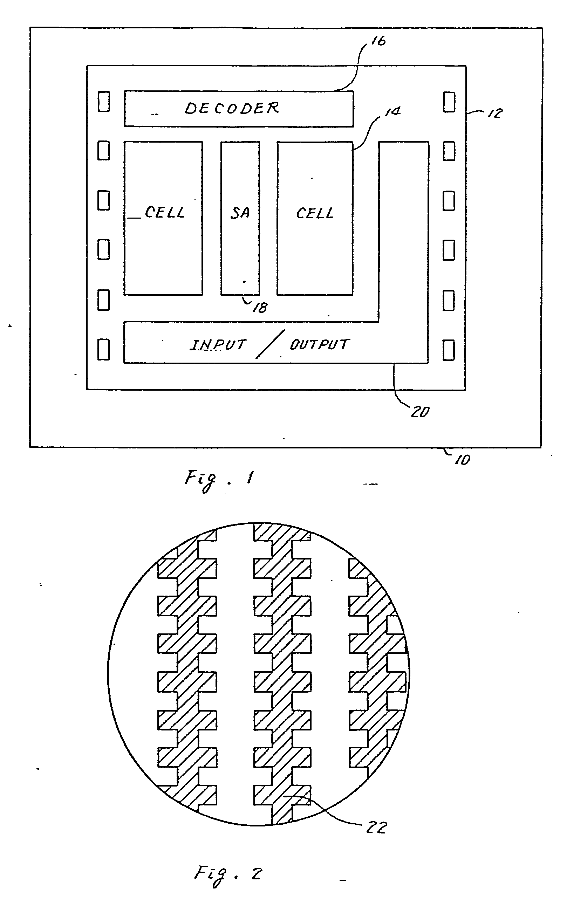

Figure 1 is a schematic plan view of a mask substrate 10 which, in the context of the present invention, is an object to be inspected. This mask substrate 10 is used for a VLSI memory for example. Pattern regions corresponding to a memory cell region 14, a decoder 16, a sense amplifier 18 and an input-output portion 20, etc. are contained in patterning 12 corresponding to a chip. Within the pattern region corresponding to memory cell region 14 a basic pattern of a 1-bit memory cell is repeatedly formed.

Figure 2 is a schematic plan view, to an enlarged scale, of the cell pattern in the pattern region corresponding to the memory cell region. The patterning 22 involved features a repeating pattern as is clear from Figure 2.

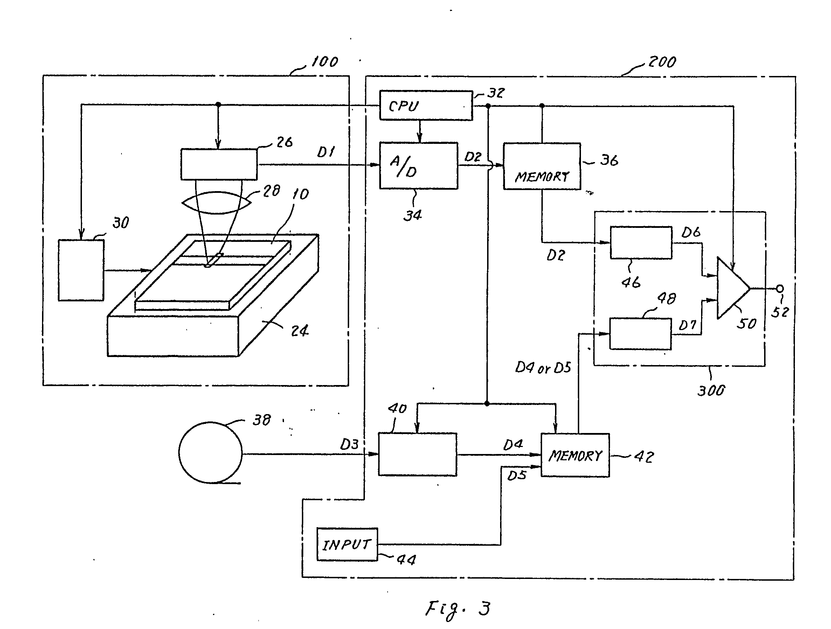

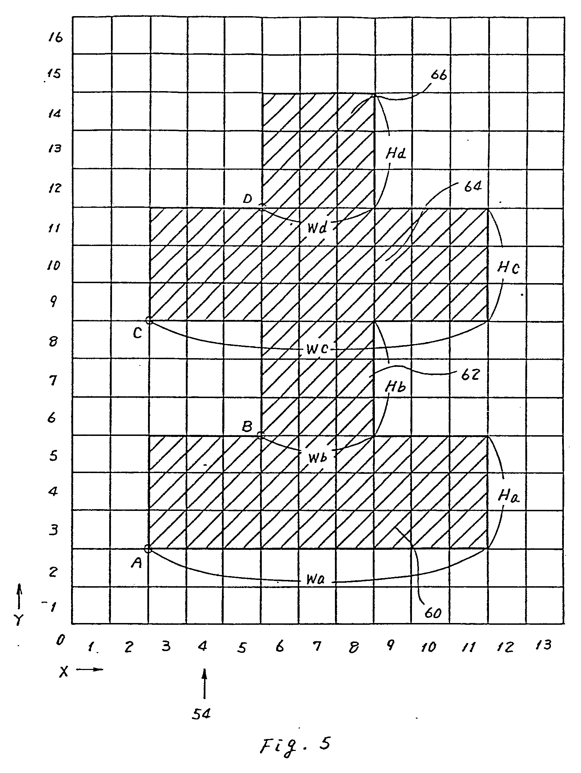

Figure 3 is a schematic block diagram of pattern inspection apparatus according to an embodiment of the present invention. As a whole, the apparatus comprises a scanning part 100, a main unit 200 and a comparison part 300 within the main unit 200.

The scanning part 100 includes a stage 24 for carrying a reticle or a mask substrate 10 which becomes a mask, a photo-electric converting part 26 which serves to convert an optical signal derived from the patterning on the mask substrate 10 into an electrical signal, an optical system 28 provided for an image sensor which works in cooperation with the photo-electric converting part 26, and a stage controller 30 which serves to control movement of the stage 24 in X and Y directions. The photo-electric converting part 26 and stage controller 30 are controlled by synchronous (synchronising) and control signals, etc. sent from a CPU 32.

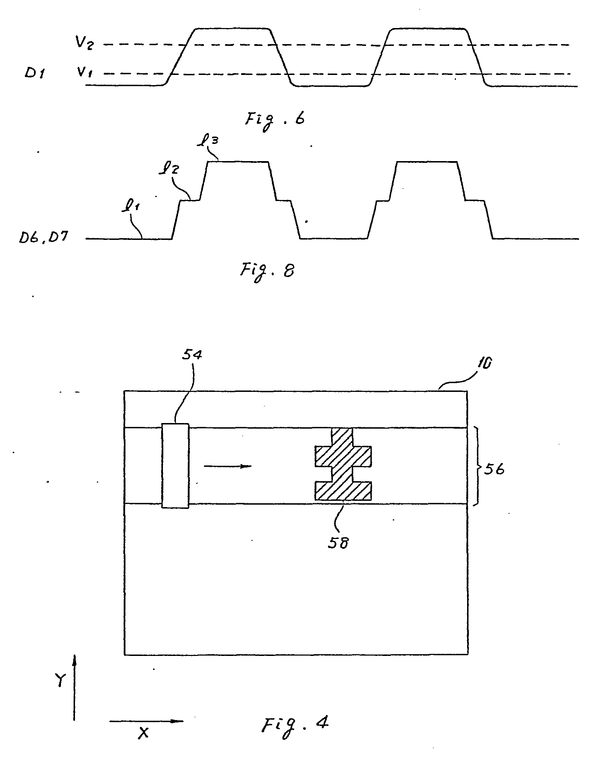

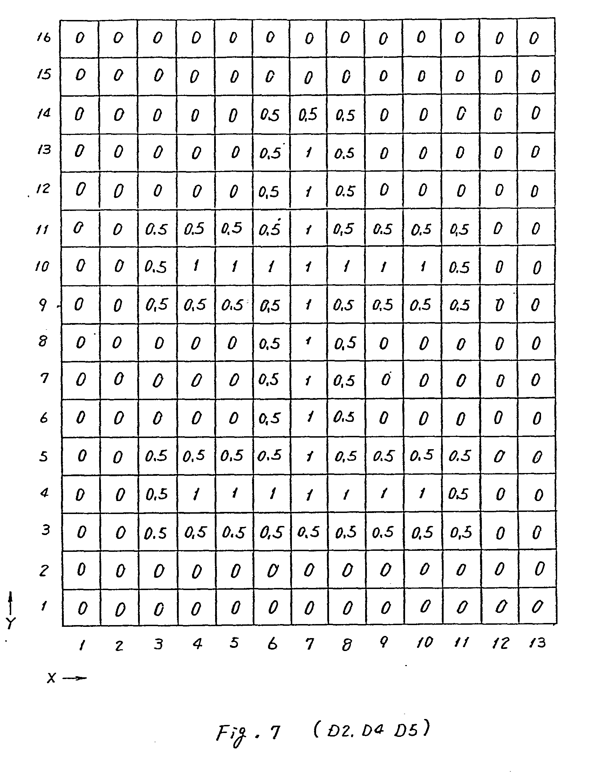

Figure 4 is a schematic plan view illustrating how mask substrate 10 is scanned. The mask substrate 10 is placed on the stage 24 and is moved in X and Y directions. In Figure 4, 54 indicates a region or zone which is viewed or sensed simultaneously by the image sensor (the field of view of the sensor). For example, a region as large as 1024 bits can be sensed, for example, in the direction Y. When the stage 24 moves in the direction X, the mask substrate 10 is scanned from the one end to the other with a width 56 — a scanning line (Y direction) width. The substrate is entirely scanned by movement (displacement) of such a scanning region or scanning line in the direction Y (e.g. by scanning in a series of lines).

For the purpose of providing a more concrete description, by way of example it will be assumed that the region (field view) 54 for sensing by the image sensor comes on or encounters a pattern part 58 as shown in Figure 4 in the scanning region of scanning line illustrated. Figure 5 is a schematic diagram, to an enlarged scale as compared with Figure 4, showing a basic pattern described in more detail later and referred to here for assistance in explaining the pattern part 58 to which the basic pattern corresponds, as can be seen. Moreover, it will also be assumed that the region 54 to be sensed by the image sensor (the field view of the sensor) shown in Fig. 4 comes to the longitudinal area in the direction X among the bit section and the region 54 has the area of 16 bits for the simplification. (It will be assumed that the field of view of the sensor has reached a position corresponding to that indicated by 54 in Figure 5 — the field of view travelling in the direction of increasing X in Fig. 5 as it travels a scanning line — and that the field of view has an area of 16 bit elements, e.g. one column, in Figure 5). In this case, the image sensor senses that the regions indicated by 1, 2, 6, 7, 8, 12—16 bits in the direction Y (the bit elements identified by Y values 1, 2, 6, 7, 8, 12—16 in the field view of column 5) are white patterns (pattern elements), while the regions indicated by 3 to 5 and 9 to 11 bits in the Y direction are black patterns (pattern elements). Optical signals provided from the image sensor are outputs as an analog electrical signal, which is a pattern inspection signal D1 in Figure 3. Figure 6 illustrates the waveform of such a pattern inspection signal D1. The two high levels in the waveform correspond to the black patterns (pattern elements) of the 3rd to 5th and 9th to 11th bits in the Y direction in Figure 5.

The pattern inspection signal D1 thus obtained is shaped and is converted into a digital signal bit by bit by A/D conversion means 34 seen in Figure 3. This provides (digital) pattern inspection data D2. In this conversion, the analog pattern inspection signal is sorted (divided) into white "0", grey "0.5" and black "1" data, depending upon the signal level being higher or lower than each of two levels $V_1$ and $V_2$ as shown in Figure 6. Namely, a signal lever lower than level $V_1$ is defined as a white level, a signal level between the levels $V_1$ and $V_2$ is defined as a grey level and a signal level higher than the level $V_2$ is defined as a black level. Here, if it is assumed that pattern inspection data D2 corresponding to the pattern

in the 13×16 bit region shown in Fig. 5 is obtained, the patterning indicated in Figure 7 can be obtained.

Namely, the boundary between white and black patterns becomes grey level "0.5", black area becomes black level "1", and white area becomes white level "0".

Such (digital) pattern inspection data D2 is sequentially output (from the A/D converter 34) in accordance with the scanning operation and is stored in an inspected bit pattern memory means 36 of the main unit 200 in Figure 3. The pattern inspection data D2 shown in Figure 7 indicates data relating to a scanned region of 13 bits extent in the X direction.

In Figure 3, 38 is a magnetic tape which stores original data D3 which is equal to (the same as) that used by a pattern generator in order to form the patterning on the mask substrate 10. Although magnetic tape is used in Figure 3, any other type of storage medium can be used as appropriate. Since this original data D3 employs a data base (a data format) suited to actual pattern formation, it is quite different from the pattern inspection signal D1 obtained by the image sensor and from the pattern inspection data D2 obtained by directly digitizing such signal D1.

For example, original data corresponding to the pattern indicated by the hatched area in Figure 5 will be explained. This pattern is divided into four rectangular areas 60, 62, 64 and 66. Regarding the shape 60, a coordinate reference (e.g. (3, 3)) for a point (corner) A of the shape 60, with respect to an origin O, and width $W_a$ and height $H_a$ of the shape 60 are stored as data (as part of original data D3). In the same way, regarding the shape 62, a coordinate reference (6, 6) of a point B, and width $W_b$ and height $H_b$ of the shape are stored. For shape 64, a coordinate reference (3, 9) of a point C, and width $W_c$ and height $H_c$ are stored. For shape 66, a coordinate reference (6, 12), and width $W_d$ and height $H_d$ are stored. Namely, in respect of the 13×16 bit range shown in Figure 5, original data D3 as indicated by (3, 3), $W_a$, $H_a$, (6, 6), $W_b$, $H_b$, (3, 9), $W_c$, $H_c$, (6, 12), $W_d$, $H_d$) is provided.

As explained above, the original data D3 is provided on a data base (in a form) suited to pattern formation and since it is not based on (bit elements) bit units such as picture elements, such data is not suitable for use in pattern inspection. Accordingly, the original data D3 is converted to data based on bit units (picture elements) by an original data conversion means 40. The original pattern data D4 obtained as a result of such conversion is data of the same kind as pattern inspection data D2 shown in Figure 7. Such a data conversion can be realized by determining whether a pertinent location corresponds to a white level "0", or a grey level, "0.5" or a black level "1", with reference to the pattern data formed by the original data D3 for each bit position, but such conversion takes time. The presence of a grey level "0.5" can be determined, for example, by the application of a rule such that a predetermined range between white and black regions is defined as grey.

The original pattern data D4 output from the original data conversion means 40 is stored in original pattern memory means 42 under the control of CPU 32.

44 is an input means which is capable of inputting specified data to the original pattern memory 42.

In the case of apparatus for pattern inspection according to this embodiment of the present invention, for execution of inspection by scanning a pattern portion of high density patterning on the mask substrate 10 other than a pattern portion which features a repeating basic pattern, e.g. of a memory cell, etc., the original data D3 sent from the magnetic tape 38 is sequentially converted into original pattern data D4, for each bit, in synchronization with scanning, in the original data conversion circuit 40 and is then temporarily stored in the original pattern memory 42. The pattern inspection signal D1 obtained from the scanning part 100 is converted to pattern inspection data D2 and the data D4 is compared sequentially with the inspected pattern data D2, stored in the inspected pattern memory 36, by the comparator 300 and when a fault in patterning is detected on the basis of this comparison an indication is provided at an output 52.

The comparator 300 comprises a converter 46 which converts the pattern inspection data D2 into an inspected comparison signal D6, a converter 48 which converts the original pattern data D4 into an original comparison signal D7 and a comparator 50 which compares the signals D6 and D7. The signals D6 and D7 are of the same kind as shown in Figure 8. Namely, a "white" signal level corresponds to a level $I_1$, a "grey" signal level corresponds to a level $I_2$, and a "black" signal level corresponds to a level $I_3$, respectively. Position along the horizontal axis (in the left to right direction) in Figure 8 corresponds equivalently to position along the horizontal axis (in the left to right direction) in Figure 6.

When executing inspection by scanning of a repeated pattern portion of the high density patterning on the mask substrate 10, where a basic pattern is formed repeatedly, as in the memory cell region, the original data D3 obtained from the magnetic tape 38 is not used. Rather, repeated basic pattern data D5 corresponding to the basic pattern (e.g. data specifying the basic pattern itself without repeating) is input to the original pattern memory 42 from an input part 44, and the data D5 is repeatedly compared with the pattern inspection data D2 by the comparator 300. The repeated basic pattern data D5 as illustrated in Figure 7, in a case in which the pattern indicated by the hatched area in Figure 5 is taken to the basic pattern. The basic pattern is usually very much smaller than a random pattern, and therefore a long time is not required for the input of such basic pattern data. Moreover, since it is not required to sequentially convert original data D3 corresponding to the repeating of the basic pattern (to every repeat of the basic pattern) by the original data conversion means 40 in synchronization with the scanning, the scanning speed of the scanning part 100 can be increased and thereby inspection time can be drastically curtailed. The reason for that is that it is not necessary to convert the data of each cell again and again and again.

Moreover, is is not required to store on the magnetic tape 38 original data D3 corresponding to the repeating of the basic pattern (every repeat of the basic pattern) and the amount of tape used can be drastically reduced.

In this embodiment of the present invention, repeated basic pattern data D5 is input to the original pattern memory 42 from the input means 44. However, the present invention is not limited to these means. For example, it is alternatively possible to provide that original data D3 concerning the basic pattern is input to the original data converter 40 from the magnetic tape 38, and then converted into the repeated basic pattern data D5, and then input to the original pattern memory 42. The data D5 is then repeatedly compared. It is also possible that an output is partly modified and it is input to the original pattern memory 42, in case at least one repeated basic pattern of outputs of A/D cohverter 34 is proved to be correct.

According to embodiments of the present invention, as explained above, it is not necessary to sequentially convert original data D3 for all regions of a mask patterning into original pattern data D4 bit by bit in synchronization with scanning of a mask substrate. When inspection of a repeated pattern portion of the mask substrate is being carried out the need for repeated conversion of original data corresponding to this portion is avoided and therefore inspection time can be curtailed to a large extent. Moreover, according to embodiment of the present invention, it is no longer necessary to store in advance in a storage medium such as magnetic tape 38, etc., all original data in respect of a repeated pattern portion. Thus storage medium requirements can be drastically reduced.

It will be appreciated that in the context of the present invention the term mask substrate used herein is employed also to designate a reticle, or a mask or any other suitable medium for bearing high density patterning to be inspected.

## Claims

1. A method of pattern inspection, comprising comparison of a signal obtained by scanning a mask substrate having high density patterning with a repeated pattern portion, in which a basic pattern is repeated, and a signal obtained from original data designating the high density patterning; which method involves:

repeatedly comparing pattern inspection data, corresponding to the signal obtained by scanning the mask substrate, and repeated basic pattern data, corresponding to the basic pattern of the repeated pattern portion, when inspecting the repeated pattern portion, and

comparing pattern inspection data, corresponding to the signal obtained by scanning the mask substrate, and original pattern data obtained by sequentially converting the original data in synchronization with the scanning, when inspecting a portion of the high density patterning other than the repeated pattern portion.

2. Pattern inspection apparatus, for inspecting high density patterning on a mask substrate (10), formed on the basis of original data, the high density patterning having a repeated pattern portion in which a basic pattern is repeated, the apparatus comprising:

a scanning means (100) operable to photoelectrically convert an optical signal obtained by scanning the mask substrate (10) and to output a pattern inspection signal (D1),

an A/D conversion (34) means operable to convert the pattern inspection signal (D1) from analog to digital form and to output pattern inspection data (D2),

an original data conversion means (40) operable to sequentially convert the original data (D3) of the high density patterning in synchronization with the scanning and to output original pattern data (D4),

an original pattern memory means (42) operable to temporarily store the original pattern data (D4),

an input means (44) operable to input repeated basic bit pattern data (D5), corresponding to the basic pattern of the repeated pattern portion, to the original pattern memory means (42), and

a control and a comparison means (32, 300) operable to input the repeated basic pattern data to the original pattern memory means from the input means when the scanning means scans the repeated pattern portion and to repeatedly compare such data with the pattern inspection data, and operable to input the original pattern data to the original pattern memory means from the original data conversion means when the scanning means scans a region other than the repeated pattern portion and to sequentially compare such data with the pattern inspection data.

## Patentansprüche

1. Verfahren zur Musterinspektion, mit dem Vergleich eines Signals, welches durch Abtasten eines Maskensubstrates erhalten wird, das eine hochdichte Musterung mit wiederholten Musterabschnitten hat, bei dem ein Basismuster wiederholt wird, mit einem Signals welches von ursprünglichen Daten erhalten wird, die die hochdichte Musterung bestimmen, welches Verfahren umfaßt:

wiederholtes Vergleichen von Musterinspektionsdaten, die dem Signal entsprechen, das durch Abtasten des Markensubstrats erhalten wird, und von wiederholten Basismusterdaten, die dem Basismuster des wiederholten Musterabschnittes entsprechen, wenn der wiederholte Musterabschnitt inspiziert wird, und

Vergleichen von Musterinspektionsdaten, die dem Signal entsprechen, das durch Abtasten des Maskensubstrats erhalten wird, mit ursprünglichen Musterdaten, die durch sequentielles Konvertieren der ursprünglichen Daten synchron mit dem Abtasten erhalten werden, wenn ein Abschnitt der hochdichten Musterung inspiziert wird, der von dem wiederholten Musterabschnitt verschieden ist.

2. Musterinspektionsvorrichtung zum Inspizieren von hochdichten Musterungen auf einem Maskensubstrat (10), die auf der Basis von ursprünglichen Daten gebildet ist, welche hochdichte Musterung einen wiederholten Musterabschnitt hat, in dem ein Basismuster wiederholt ist, welche Vorrichtung umfaßt:

eine Abtasteinrichtung (100), die betreibbar ist, um fotoelektrisch ein optisches Signal zu konvertieren, welches durch Abtasten des Maskensubstrates (10) erhalten wird, und um ein Musterinspektionssignal (D1) auszugeben,

eine A/D-Konversionseinrichtung (34), die betreibbar ist, um das Musterinspektionssignal (D1) aus analoger Form in digitale Form zu wandeln, und um Musterinspecktionsdaten (d2) auszugeben,

eine Ursprungsdaten-Konversionseinrichtung (40), die betreibbar ist, um sequentiell die ursprünglichen Daten (D3) der hochdichten Musterung synchron mit dem Abtasten zu konvertieren und ursprüngliche Musterdaten (DL) auszugeben,

eine Ursprungsmuster-Speichereinrichtungen (42), die betreibbar sind, um temporär die ursprünglichen Musterdaten (D4) zu speichern,

une eine Eingabeeinrichtung (44), die betreibbar sind, um in ide Ursprungsmuster-Speichereinrichtung (42) wiederholte Basisbitmusterdaten (D5) einzugeben, die dem Basismuster des wiederholten Musterabschnitts entsprechen, und

eine Steuer- und Vergleichseinrichtung (32, 300), die betreibbar ist, un die wiederholten Basismusterdaten von der Eingabeeinrichtung in die Ursprungsmuster-Speichereinrichtung einzugeben, wenn due Abtasteinrichtung den wiederholten Musterabschnitt abtastet, und um wiederholt solche Daten mut den Musterinspektionsdaten zu vergleichen, und betreibbar ist, um die ursprünglichen Musterdaten von der Ursprungsdaten-Konversionseinrichtung in die Ursprungsmuster-Speichereinrichtung einzugeben, wenn die Abtasteinrichtung einen von dem wiederholten Musterabschnitt verschiedenen Abschnitt abtastet, und um sequentiell solche Daten mit den Musterinspektionsdaten zu vergleichen.

**Revendications**

1. Procédé d'inspection de motifs, comprenant la comparaison d'un signal obtenu par balayage d'un substrat de masque possédant un tracé de motifs à haute densité qui comporte une partie à motif répétitif, dans lequel un motif de base est répété, et d'un signal obtenu à partir de données initiales désignant le tracé de motif à haute densité;

lequel procédé comporte les opérations suivantes:

comparer de manière répétée les données d'inspection de motif, correspondant au signal obtenu par balayage du substrat de masque, et les données de motif de base répétitif, correspondant au motif de base de la partie à motif répétitif, lors de l'inspection de la partie à motif répétitif, et

comparer les données d'inspection de motif, correspondant au signal obtenu par balayage du substrat de masque, et les données de motif initial obtenues par conversion séquentielle des données initailes en synchronisme avec le balayage, lors de l'inspection d'une partie du tracé de motif à haute densité autre que la partie à motif répétitif.

2. Appareil d'inspection de motifs, permettant d'inspecter un tracé de motifs à haute densité d'un substrat de masque (10), formé sur la base de données initiales, le tracé de motifs à haute densité possédant un partie à motif répétitif dans laquelle un motif de base est répété, l'appareil comprenant:

un moyen de balayage (100) ayant pour fonction de convertir photoélectriquement un signal optique obtenu par balayage du substrat de masque (10) et de délivrer un signal d'inspection de motif (D1),

un moyen de conversion analogigue-numérique (34) ayant pour fonction de convertir le signal d'inspection de motif (D1) de la forme analogique à la forme numérique et de délivrer des données d'inspection de motif (D2),

un moyen (40) de conversion de données initiales ayant pour fonction de séquentiellement convertir les données initiales (D3) du tracé de motif à haute densité en synchronisme avec le balayage et de délivrer des données de motif initial (D4),

um moyen (42) de mémorisation de motif initial ayant pour fonction d'emmagasiner temporairement les données de motif initial (D4),

un moyen d'entrée (44) ayant pour fonction de fournir des données de motif de bits de base répétitif (D5), correspondant au motif de base de la partie à motif répétitif, au moyen (42) de mémorisation de motif initial, et

un moyen de commande de comparaison (32, 300) ayant pour fonction de fournir les données de motif de base répétitif au moyen de mémorisation de motif initial à partir du moyen d'entrée lorsque le moyen de balayage balaye la partie à motif répétitif et de comparer à répétition ces données avec les données d'inspection de motif, et ayant pour fonction de fournir les données de motif initial au moyen de mémorisation de motif initial à partir du moyen de conversion de données initiales lorsque le moyen de balayage balaye une région autre que la partie à motif répétitif et de comparer séquentiellement ces données avec les données d'inspection de motif.

Fig . 1

Fig . 2

1

Fig. 3

EP 0 147 205 B1

Fig. 5

$V_2$ -----

$D1$ $V_1$ -----

Fig. 6

$\ell_3$

$\ell_2$

$\ell_1$

$D6, D7$

Fig. 8

54

10

56

58

Y

X

Fig. 4

| Y\X | 1 | 2 | 3 | 4 | 5 | 6 | 7 | 8 | 9 | 10 | 11 | 12 | 13 |
|---|---|---|---|---|---|---|---|---|---|---|---|---|---|
| 16 | 0 | 0 | 0 | 0 | 0 | 0 | 0 | 0 | 0 | 0 | 0 | 0 | 0 |
| 15 | 0 | 0 | 0 | 0 | 0 | 0 | 0 | 0 | 0 | 0 | 0 | 0 | 0 |
| 14 | 0 | 0 | 0 | 0 | 0 | 0,5 | 0,5 | 0,5 | 0 | 0 | 0 | 0 | 0 |
| 13 | 0 | 0 | 0 | 0 | 0 | 0,5 | 1 | 0,5 | 0 | 0 | 0 | 0 | 0 |
| 12 | 0 | 0 | 0 | 0 | 0 | 0,5 | 1 | 0,5 | 0 | 0 | 0 | 0 | 0 |
| 11 | 0 | 0 | 0,5 | 0,5 | 0,5 | 0,5 | 1 | 0,5 | 0,5 | 0,5 | 0,5 | 0 | 0 |
| 10 | 0 | 0 | 0,5 | 1 | 1 | 1 | 1 | 1 | 1 | 1 | 0,5 | 0 | 0 |
| 9 | 0 | 0 | 0,5 | 0,5 | 0,5 | 0,5 | 1 | 0,5 | 0,5 | 0,5 | 0,5 | 0 | 0 |
| 8 | 0 | 0 | 0 | 0 | 0 | 0,5 | 1 | 0,5 | 0 | 0 | 0 | 0 | 0 |
| 7 | 0 | 0 | 0 | 0 | 0 | 0,5 | 1 | 0,5 | 0 | 0 | 0 | 0 | 0 |
| 6 | 0 | 0 | 0 | 0 | 0 | 0,5 | 1 | 0,5 | 0 | 0 | 0 | 0 | 0 |
| 5 | 0 | 0 | 0,5 | 0,5 | 0,5 | 0,5 | 1 | 0,5 | 0,5 | 0,5 | 0,5 | 0 | 0 |
| 4 | 0 | 0 | 0,5 | 1 | 1 | 1 | 1 | 1 | 1 | 1 | 0,5 | 0 | 0 |
| 3 | 0 | 0 | 0,5 | 0,5 | 0,5 | 0,5 | 0,5 | 0,5 | 0,5 | 0,5 | 0,5 | 0 | 0 |
| 2 | 0 | 0 | 0 | 0 | 0 | 0 | 0 | 0 | 0 | 0 | 0 | 0 | 0 |
| 1 | 0 | 0 | 0 | 0 | 0 | 0 | 0 | 0 | 0 | 0 | 0 | 0 | 0 |

$Y \uparrow$  $X \longrightarrow$

Fig . 7   ( D2. D4 D5 )